# EUROPEAN PATENT APPLICATION

(11) **EP 4 722 736 A1**
(43) Date of publication of application: **08.04.2026**
(21) Application number: 24204078.0
(22) Date of filing: 01.10.2024
(51) Int. Cl.: G01Q 10/04, G01Q 30/20, G01Q 70/02, H01J 37/20

(54) **POSITIONING SYSTEM FOR NANOSCALE POSITIONING**

(71) Applicant: Nanosurf AG, 4410 Liestal (CH)
(72) Inventor: LIEB, Andreas, 4410 Liestal (CH); PIETZAK, Björn, 4410 Liestal (CH)
(74) Representative: Dumlich, Heiko Alexander

(57) **Abstract**

The present invention relates to a positioning system (10') for nanoscale positioning. It comprises a support structure (12), a first translation axis (14') and a second translation axis (16'). The first translation axis extends along a first direction (x), for moving a processing object (20) along the first direction and has a first translation axis width (w1) in a second direction (y) perpendicular to the first direction. The second translation axis extends along the second direction, for moving a processing tool (30) for processing the processing object along the second direction. The first and second translation axes are arranged with a distance to each other in a third direction (z) perpendicular to the first and second directions and are connected to or part of the support structure. The positioning system is configured for moving the processing tool over the whole first translation axis width without colliding with the support structure.

## Description

### FIELD OF THE INVENTION

The present invention relates to a positioning system for nanoscale positioning, a processing system including the positioning system and a processing tool, a method for operating the processing system, use of the processing system, and a corresponding computer program product as well as a computer readable medium having stored the computer program product. The positioning system may for example be or include a stage and the processing tool may for example be or include a scanning probe microscope (SPM), e.g., an atomic force microscope (AFM).

### BACKGROUND OF THE INVENTION

US 7,687,767 B2 discloses a fast scanning stage for a SPM. The stage includes at least one axis of translation driven at the natural resonant frequency of the translation stage such that distortion associated with rapid changes in scan direction is avoided. In one embodiment, the stage includes a sample plate or support that is driven, preferably by one or more piezoelectric actuator elements, so that the plate translates along the fast scan frequency at its resonant frequency.

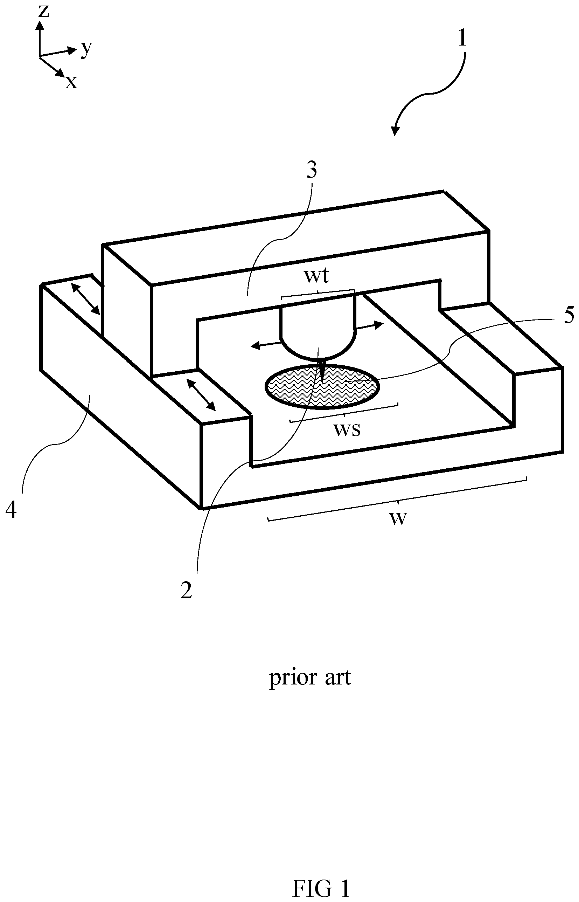

Fig. 1 presents a typical positioning system 1 for a processing tool 2 known from the prior art. The positioning system 1 has a solid bar 3 arranged on a solid support structure 4 forming a bridge from one part of the support structure 4 to another part of the support structure 4. The processing tool 2 is attached as firmly as possible to the solid bar 3 in such a way that it can slide in a y-direction underneath the solid bar 3. The solid bar 3 can slide in the x-direction, orthogonal to the y-direction, with respect to the support structure 4. A processing object in form of a sample 5 can be arranged on the support structure 4 underneath the solid bar 3. Various incarnations of such a scheme are known. For example, in those in which the processing tool 2 needs to contact the sample 5, typically a probe of the processing tool 2 can move in the z-direction, orthogonal to the x- and y-directions, to contact the sample 5.

### SUMMARY OF THE INVENTION

It can be seen as an object of the present invention to provide a positioning system for nanoscale positioning, a processing system including the positioning system and a processing tool, a method for operating the processing system, use of the processing system, and a corresponding computer program product as well as a computer readable medium having stored the computer program product which allow to carry out nanoscale positioning at lower noise, higher positioning stability, and/or higher speed.

In a first aspect of the present invention a positioning system for nanoscale positioning is presented. The positioning system comprises a support structure, a first translation axis and a second translation axis. The first translation axis extends along a first direction and is configured for moving a processing object along the first direction. The first translation axis has a first translation axis width in a second direction perpendicular to the first direction. The second translation axis extends along the second direction and is configured for moving a processing tool for processing the processing object along the second direction, the processing tool having a second static processing length in the second direction defining a length over which the processing tool processes the processing object without moving the processing tool in the second direction. The first translation axis is connected to or part of the support structure. The second translation axis is connected to or part of the support structure. The first translation axis and the second translation axis are arranged with a distance to each other in a third direction perpendicular to the first direction and the second direction. The positioning system is configured for moving the second static processing length over the whole first translation axis width without colliding with the support structure.

For any suspended structures such as the solid bar 3 spanning over the support structure 4 in form of a bridge as known from positioning systems 1 from the prior art (cf. Fig. 1), the stability and resonance frequencies of the positioning system degrade with increasing span of the solid bar over the support structure. Rigidity is provided by the choice of materials and by keeping a mechanical loop from the processing tool 2 to the sample 5 as short as possible. To ensure that the probe on the processing tool 2 can be moved to any position on the sample 5, the solid bar 3 needs to span a distance w that is at least the width ws of the sample 5 plus the width wt of the processing tool 2.

Since the inventive positioning system is configured for moving the second static processing length over the whole first translation axis width without colliding with the support structure, i.e., such that the processing tool does not collide with the support structure when processing the processing object over its whole processing length in the first direction, a processing object may be arranged at the first translation axis and processed over its whole width that has a width in the second direction equal to the first translation axis width. In other words, a span of the second translation axis may be reduced to the first translation axis width while maintaining the capability of processing the processing object over the whole first translation axis width. Hence, a shorter span can be achieved which allows to achieve a higher mechanical stability and higher resonance frequencies with the positioning system. Therefore, an increased stability of the positioning, in particular at nanometer length scales, can be achieved with the positioning system. The positioning system may be mechanically more compact and stable and may have higher resonance frequencies allowing nanoscale processing, such as characterization and manipulation at lower noise and/or higher speeds.

The processing object may for example be a wafer, such as a 200 mm or 300 mm wafer, including, e.g., glass or Silicon (Si). The second translation axis may be configured for moving a nanoscale processing tool for processing the processing object on the nanoscale, i.e., on the nanometer-scale.

The positioning system may comprise a tool support for supporting the processing tool. The tool support may have a tool support width larger than the second static processing length of the processing tool in the second direction. This allows to support processing tools for processing the processing object, particularly larger processing tools. The tool support may have a width in the first direction which is at least as large as a processing tool width in the first direction. The tool support may have a width in the second direction which is at least as large as a processing tool width in the second direction. The tool support may comprise, for example, a translation stage that supports the processing tool and which is moved along the second direction to move the processing tool.

The tool support width in the second direction may be smaller than the processing tool width in the second direction. In this case, the processing tool width in the second direction may be larger than the second static processing length. The tool support width in the first direction may be smaller than the processing tool width in the first direction. In this case, the processing tool width in the first direction may be larger than a first static processing length of the processing tool in the first direction defining a length over which the processing tool processes the processing object without moving the processing tool in the first direction.

The second translation axis may be configured for moving the processing tool over a second translation length in the second direction that is larger than the first translation axis width in the second direction. The second translation length extends between a lowest extension of the tool support in the second direction when at a lowest position in the second direction and a highest extension of the tool support in the second direction when at a highest position in the second direction. Since the second translation axis may be configured for moving the processing tool over a second translation length in the second direction that is larger than the first translation axis width in the second direction, the processing object may be processed over its whole width in the second direction. If the tool support width in the second direction is smaller than the processing tool width in the second direction, the second translation length may extend between a lowest extension of the processing tool in the second direction when at a lowest position in the second direction and a highest extension of the processing tool in the second direction when at a highest position in the second direction.

The second translation length may be equal to or larger than the sum of the first translation axis width and the tool support width minus the second static processing length in the second direction. Having a smaller second translation length may allow to have a smaller span and higher mechanical stability. If the tool support width in the second direction is smaller than the processing tool width in the second direction, the second translation length may be equal to or larger than the sum of the first translation axis width and the processing tool width minus the second static processing length in the second direction.

The support structure may comprise at least one lateral opening or lateral recess at at least one side of the support structure in the second direction. The lateral opening or lateral recess may be at least as large as extensions of the processing tool and/or the tool support such that the processing tool and/or the tool support can move through the at least one lateral opening or move into the at least one lateral recess without colliding with the support structure when the second static processing length is moved over the whole first translation axis width. If the processing tool and/or the tool support have only an extension to one of its sides in the second direction which extends over the second static processing length, one lateral opening or lateral recess may be sufficient on the side with the extensions. The lateral opening or lateral recess may be at least as large as respective extensions of the processing tool and/or tool support which move through the at least one lateral opening or moves into the at least one lateral recess. Providing the support structure with a lateral opening or lateral recess into which the processing tool and tool support can move, allows to reduce the span and thus to improve mechanical stability.

The support structure may comprise at least one lateral opening or lateral recess at at least one side of the support structure in the first direction. The lateral opening or lateral recess may be at least as large as extensions of the processing object and/or a stage for supporting the processing object such that the processing object and/or the stage for supporting the processing object can move through the at least one lateral opening or move into the at least one lateral recess without colliding with the support structure when the processing object and/or the stage for supporting the processing object is moved along the first direction.

The support structure may have four pillars extending in the third direction. The first translation axis may be arranged between the four pillars. Alternatively, or additionally, the second translation axis may be arranged between the four pillars. This allows arranging the first translation axis and the second translation axis as crossed axes with reduced span between the pillars. This allows increasing stability and reducing noise or increasing positioning speed.

The first translation axis width may be equal to or above 200 mm, e.g., 300 mm to support 200 mm wafers or 300 mm wafers, respectively. 200 mm wafers may be 200 mm diameter wafers or square wafers with 200 mm x 200 mm size and 300 mm wafers may be 300 mm diameter wafers or square wafers with 300 mm x 300 mm size. The second translation axis has a second translation axis width in the first direction. The second translation axis width in the first direction may be equal to or above 200 mm, e.g., 300 mm to allow the first translation axis to support 200 mm wafers or 300 mm wafers, respectively. This allows supporting standard sized semiconductor wafers.

A span between two of the pillars of the support structure in the second direction may be equal to the first translation axis width. This allows to provide a minimal span and to improve mechanical stability. The span between each two respective pillars of the support structure in the second direction may be equal to the first translation axis width. A span between two of the pillars of the support structure in the first direction may be equal to the second translation axis width. The span between each two respective pillars of the support structure in the first direction may be equal to the second translation axis width. The span between each two respective pillars of the support structure in the second direction may be equal to the first translation axis width and the span between each two respective pillars of the support structure in the first direction may be equal to the second translation axis width. In this case a cubic volume with a quadratic area is provided between the first translation axis and second translation axis which has a minimal span between the four pillars for processing a respectively sized, e.g., quadratic or circular, processing object, such as a wafer, by a processing tool. The processing object may be partly arranged within the volume in the first direction while fully arranged in the second direction and may be moved through the volume in the first direction. The processing tool may be partly arranged in the volume in the second direction while fully arranged in the first direction and may be moved through the volume in the second direction for processing the processing object. This allows providing a positioning system with improved mechanical stability and thus improved measurement capabilities, e.g., higher speed and/or lower noise. The first translation axis width may be, for example, 200 mm, to support 200 mm wafers or 300 mm to support 300 mm wafers and the second translation axis width may be equal to the processing tool width in the first direction or the tool support width in the first direction. Alternatively, the first translation axis width and the second translation axis width may also be equal, for example, 200 mm, to support 200 mm wafers or 300 mm to support 300 mm wafers. This allows for providing a positioning system of high symmetry, which may improve stability.

The support structure may have two bars extending in the second direction. The support structure may have two bars extending in the first direction. The pillars may be connected to one bar extending in the second direction and one bar extending in the first direction. Each of the bars extending in the second direction may be connected to two pillars. Each of the bars extending in the first direction may be connected to two pillars. This allows to provide a compact positioning system structure with two crossed axes and minimal span.

The first translation axis may be connected to the two bars extending in the first direction. The second translation axis may be connected to the two bars extending in the second direction. The second translation axis may be connected to the support structure on both of its sides in the first direction. The first translation axis may be connected to the support structure on both of its sides in the second direction.

The first translation axis may have a first translation axis length in the first direction equal to or above 200 mm to support 200 mm wafers or equal to above 300 mm to support 300 mm wafers. The second translation axis may have a second translation axis length in the second direction equal to or above 200 mm to enable that the first translation axis can support 200 mm wafers, or equal to or above 300 mm to enable that the first translation axis can support 300 mm wafers.

The first translation axis may include at least one rail for supporting a first translation stage for supporting the processing object. The first translation axis may be configured for moving the first translation stage along the at least one rail in the first direction. Alternatively, or additionally, the second translation axis may include at least one rail for supporting a second translation stage for supporting the processing tool. The second translation axis may be configured for moving the second translation stage along the at least one rail in the second direction. Moving translation stages by rails instead of moving the whole translation axis may reduce weight of the positioning system and moving parts which may improve mechanical stability and reduce operation costs as less energy is required for moving processing objects. Additionally, a modular design may be achieved which allows a wider choice of configurations in dependence of a fixed translation stage design.

The first translation axis may include, for example, two rails or more rails for supporting the first translation stage. The two or more rails may be configured for moving the first translation stage along the two or more rails along the first direction. The second translation axis may include, for example, two rails or more rails for supporting the second translation stage. The rails may be made of the same material as the support structure. Rails may be monorails. The first translation axis may include a support bar. Additionally, or alternatively, the second translation axis may include a support bar. The translation stages may be attached to the respective support bar.

The support structure may have a resonance frequency of equal to or above 100 Hz, preferably equal to or above 200 Hz, more preferably equal to or above 500 Hz, most preferably equal to or above 1000 Hz. The positioning system may have resonance frequencies of equal to or above 100 Hz, preferably equal to or above 200 Hz, more preferably equal to or above 500 Hz, most preferably equal to or above 1000 Hz.

The positioning system may include a strong and light material, such as composite material or carbon. Parts of the positioning system may be made of the strong and light material, e.g., translation stages and rails. The positioning system may furthermore include a hard and tough material, such as granite. The support structure may include or be made of granite. The rails may include or be made of granite. The first translation axis and the second translation axis may include or be made of granite. The support structure may be made by mineral casting.

A precision of the positioning may be equal to or below the order of 1 nm. Accuracy of an overall positioning of the static processing area may be equal to or below the order of 10 µm, e.g., between 1 µm and 10 µm or below 1 µm, for example below 100 nm, such as 10 nm.

In a further aspect of the present invention a processing system is presented. The processing system includes a processing tool and a positioning system according to any of the claims 1 to 9 or any embodiment of the positioning system. The processing tool is configured for processing the processing object. The processing tool has the second static processing length in the second direction defining the length over which the processing tool processes the processing object without moving the processing tool in the second direction.

The processing tool may have a first static processing length in the first direction defining the length over which the processing tool processes the processing object without moving the processing tool in the first direction. The first static processing length and the second static processing length can be equal in size. A static processing area results depending on the first static processing length and the second static processing length which has a form additionally depending on the processing tool. The static processing area may be, for example, circular, quadratic or may have any other form depending on the processing tool.

The processing tool may be a nanoscale processing tool configured for nanoscale processing, e.g., processing a substrate on the nanoscale. The processing tool may for example be a SPM, e.g., an AFM. The processing tool may include a scanning head of a SPM for scanning the processing object, e.g., a sample.

Nanoscale processing may include creating, characterizing, and manipulating structures on the nanoscale such as, diamond cutting, polishing, focused ion beam (FIB) milling, inspecting roughness, inspecting critical dimensions, and any other method to characterize and/or manipulate processing objects such as large samples, e.g., 300 mm semiconductor wafers at the nanoscale.

The second translation axis width in the first direction may be equal to a processing tool width in the first direction. This allows reducing the span in the first direction and to further increase stability of the processing system. The first translation axis may have a first translation axis width in the second direction equal to or smaller than the processing tool width in the second direction. This allows to provide a compact processing system with minimal second translation axis length and a low span and high stability.

Resonance frequencies of the positioning system may be at least a factor two above an effective processing bandwidth of the processing tool. This allows reducing influence of the positioning system on the processing tool results, e.g., AFM pictures when performing scans with high frequency such as 1 Hz or up to 5 Hz, preferably up to 20 Hz, more preferably up to 100 Hz or even more. The positioning system preferably has resonance frequencies above the effective processing bandwidth of the processing tool. For example, with the resonance frequencies of the positioning system of 1000 Hz, the processing tool may operate at an effective processing bandwidth of up to a few 100s Hz without being affected by the resonances of the positioning system, i.e., without noticeable effect from the resonances of the positioning system. The effective processing bandwidth of the processing tool is the bandwidth of frequencies in which processing is performed with the processing tool. The effective processing bandwidth may be, for example, an effective measurement bandwidth. The effective processing bandwidth depends on resonance frequencies of the processing tool and further factors, such as parameter settings of the processing tool.

An enhanced stiffness of the positioning system may allow reducing amplitudes of the resonances such that the effect of the resonances of the positioning system may be more readily compensated for by postprocessing, even when the effective processing bandwidth of the processing tool exceeds the resonance frequencies of the positioning system. If the resonance frequencies of the positioning system are well defined, post-processing of a measured signal is possible by removing the well-defined resonance frequencies to improve the signal.

Alternatively, or additionally, resonance frequencies of the processing system may be at least a factor two above the effective processing bandwidth of the processing tool. The resonance frequencies of the processing system include the resonance frequencies of the positioning system and the processing tool. Typically, the resonance frequencies of the processing tool are higher than the resonance frequencies of the positioning system and thus do typically not affect the effective processing bandwidth of the processing tool noticeably. The processing tool may be, for example, an AFM. In this case, the AFM typically is designed to have a high stiffness and high resonance frequencies.

In a further aspect of the present invention a method for operating a processing system according to claim 10 or 11 or any embodiment of the processing system is presented. The method comprises the steps:
- arranging a processing object on the first translation axis,
- moving the processing object along the first direction to a position below the second translation axis,
- moving the processing tool along the second direction to move the second static processing length over the whole first translation axis width such that the processing tool processes the processing object over the whole first translation axis width without colliding with the support structure.

The method may include scanning the processing object, e.g., by iteratively moving the processing tool a step along the first direction once the processing tool was moved along the second direction over the whole first translation axis width. Alternatively, the method may include scanning the processing object by moving the processing tool along the first direction over the whole second translation axis width such that the processing tool processes the processing object over the whole second translation axis width and iteratively moving the processing tool a step along the second direction once the processing tool was moved along the first direction over the whole second translation axis width. Yet alternatively, the scanning may be performed in any other scan pattern for processing a whole area of the processing object.

In a further aspect of the present invention a use of the processing system according to claim 10 or 11 or any embodiment of the processing system is presented. The processing system may be used for one or more of the following:
- characterization of a sample,
- structuring of a sample,
- performing a scanning probe microscopy measurement on a sample,
- diamond cutting,
- polishing,
- focused ion beam milling,
- performing lithography on the sample,
- local deposition of materials,
- local heating of a sample,
- inspection of roughness, or
- inspection of critical dimensions.

Various features of a sample may be characterized in various ways. For example, topographical, structural, mechanical, electrical and magnetic characterization of the sample may be performed.

Inspection of roughness and inspection of critical dimensions may be performed, for example, by AFM. For example, roughness and critical dimensions of a 300 mm semiconductor wafer may be inspected.

In a further aspect of the present invention a computer program product for operating a processing system according to claim 10 or 11, or any embodiment of the processing system is presented. The computer program product comprises program code means for causing a processor to carry out the method according to claim 12, or any embodiment of the method, when the computer program product is run on the processor.

In a further aspect a computer readable medium having stored the computer program product of claim 14 is presented. Alternatively, or additionally, the computer readable medium can have the computer program product according to any embodiment of the computer program product stored.

It shall be understood that the positioning system according to claim 1, the processing system according to claim 10, the method according to claim 12, the use according to claim 13, the computer program product according to claim 14, and the computer readable medium according to claim 15 have similar and/or identical preferred embodiments, in particular, as defined in the dependent claims.

It shall be understood that a preferred embodiment of the present invention can also be any combination of the dependent claims or above embodiments with the respective independent claim.

These and other aspects of the invention will be apparent from and elucidated with reference to the embodiments described hereinafter.

### BRIEF DESCRIPTION OF THE DRAWINGS

In the following drawings:
Fig. 1 shows schematically and exemplarily a non-inventive example of a positioning system known from the prior art in a perspective view;
Fig. 2 shows schematically and exemplarily a perspective view of a first embodiment of a processing system with a first embodiment of a positioning system and a processing tool in a perspective view;
Fig. 3 shows schematically and exemplarily a side view of the first embodiment of the processing system in the x-z plane;
Fig. 4A shows schematically and exemplarily a side view of the first embodiment of the processing system in the y-z plane;
Fig. 4B shows schematically and exemplarily a side view of the first embodiment of the processing system in the y-z plane with the processing tool in a lowest scan position in the y-direction;
Fig. 4C shows schematically and exemplarily a side view of the first embodiment of the processing system in the y-z plane with the processing tool in a highest scan position in the y-direction;
Fig. 5 shows schematically and exemplarily a top view of the first embodiment of the processing system in the x-y plane;
Fig. 6 shows schematically and exemplarily a sectional view of the first embodiment of the processing system in the x-y plane looking in the direction of the first translation axis from viewpoint A-A between the first translation axis and the second translation axis shown in Fig. 3 and Fig. 4A;
Fig. 7 shows schematically and exemplarily a perspective view of a second embodiment of a processing system with a second embodiment of a positioning system and a processing tool in a perspective view;
Fig. 8 shows schematically and exemplarily a side view of the second embodiment of the processing system in the x-z plane;
Fig. 9 shows schematically and exemplarily a side view of the second embodiment of the processing system in the y-z plane;
Fig. 10 shows an embodiment of the method for operating a processing system.

### DETAILED DESCRIPTION OF EMBODIMENTS

Fig. 1 presents a positioning system 1 known from the prior art as described in the background of the invention.

Processing, in particular on the nanoscale, such as characterization and manipulation of large processing objects typically requires precise and stable positioning of a processing tool, e.g., a characterization tool such as an AFM or a manipulation tool such as a polisher over larger areas. This in turn requires a positioning system such as a mechanical positioning stage with at least two axes that is stable at nanometer length scales. The invention provides inter alia an improved positioning system which can be included into a processing system to achieve improved mechanical positioning.

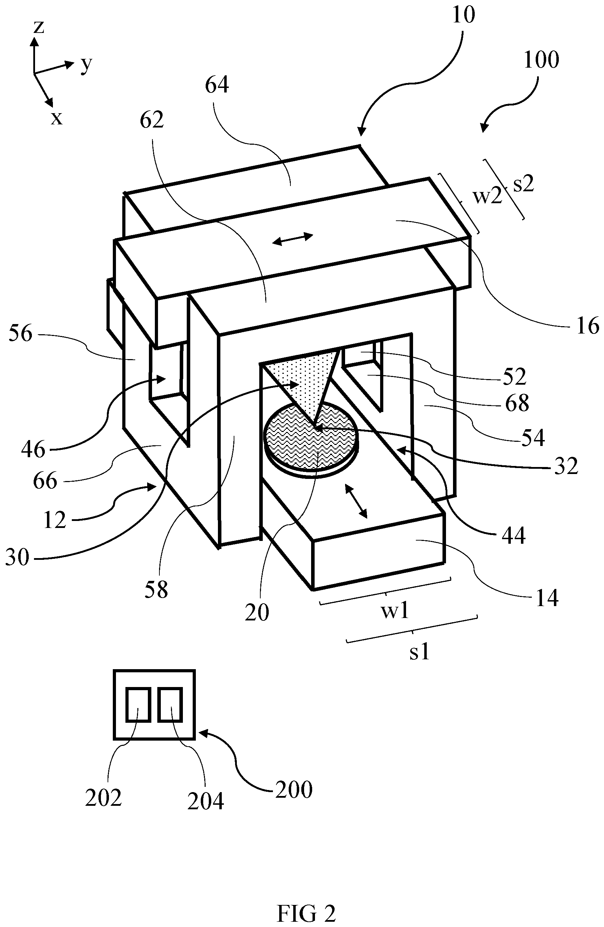

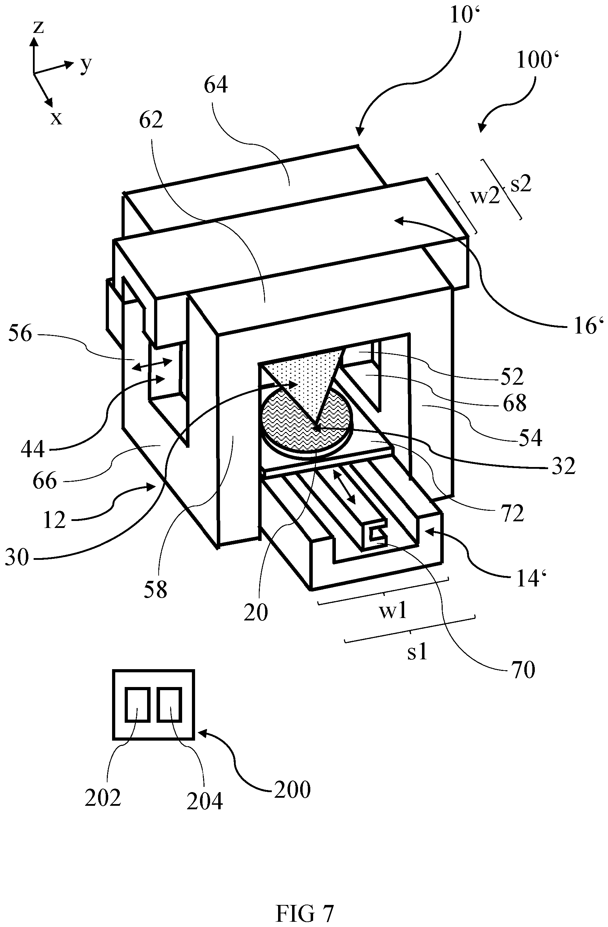

A first embodiment of a processing system 100 is presented with respect to Figs. 2 to 6 from different perspectives and a second embodiment of the processing system 100' is presented with respect to Figs. 7 to 9 from different perspectives. Same reference signs are used for same features of the embodiments. Each of the processing systems 100 and 100' comprises a processing tool 30. In the embodiments, the processing tool 30 is an AFM. The AFM can be used for inspecting roughness and critical dimensions of the processing object 20, which in the embodiments is a sample in form of a 300 mm diameter semiconductor wafer. In other embodiments, the processing systems may be used for other applications and on other processing objects depending on the processing tool mounted on the processing system and the processing object to be processed.

Fig. 2 shows schematically and exemplarily a perspective view of the first embodiment of the processing system 100 with a first embodiment of a positioning system 10 and a processing tool 30 in a perspective view. The positioning system 10 allows nanoscale positioning of the processing tool 30 with low noise and high speed such that an improved processing can be achieved. For example, for an AFM the quality of AFM images can be improved.

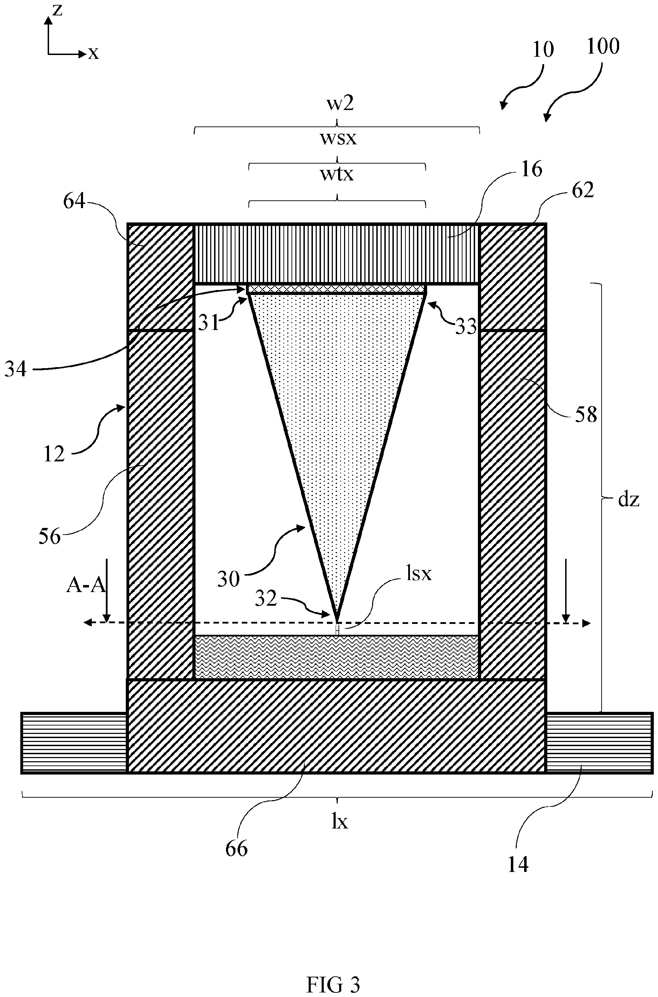

The positioning system 10 comprises a support structure 12, a first translation axis 14 extending along a first direction x, a second translation axis 16 extending along a second direction y perpendicular to the x-direction, and a tool support 34 for supporting the processing tool 30 (cf. Fig. 3).

The first translation axis 14 can be moved along the x-direction for moving the processing object 20 along the x-direction. The first translation axis 14 is connected to the support structure 12 and can slide along the support structure 12 in the x-direction to move the processing object 20. The first translation axis 14 has a first translation axis width w1 in the y-direction and a first translation axis length lx in the x-direction (cf. Fig. 3).

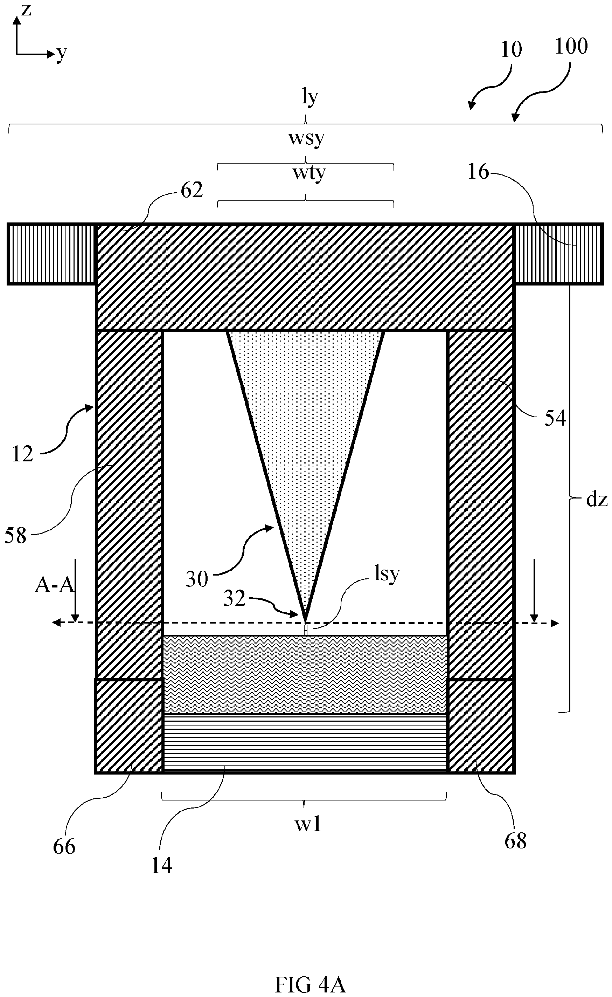

The second translation axis 16 can be moved along the y-direction for moving the processing tool 30. The second translation axis 16 is connected to the support structure 12 and can slide along the support structure 12 in the y-direction to move the processing tool 30. The processing tool 30 can thus process the processing object 20 along the y-direction. The second translation axis 16 has a second translation axis width w2 in the x-direction and a second translation axis length ly in the y-direction (cf. Fig. 4A).

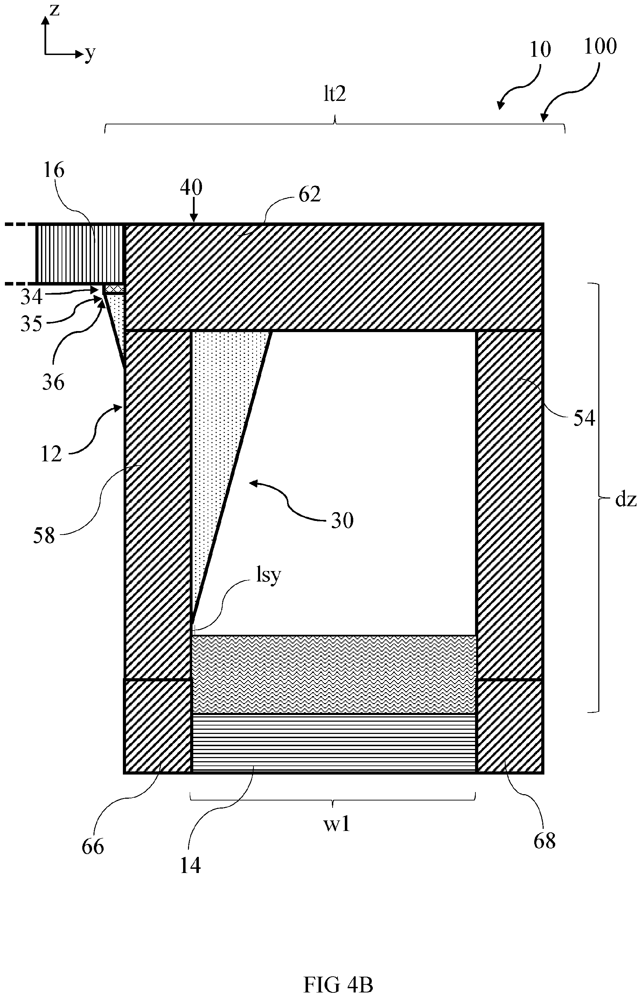

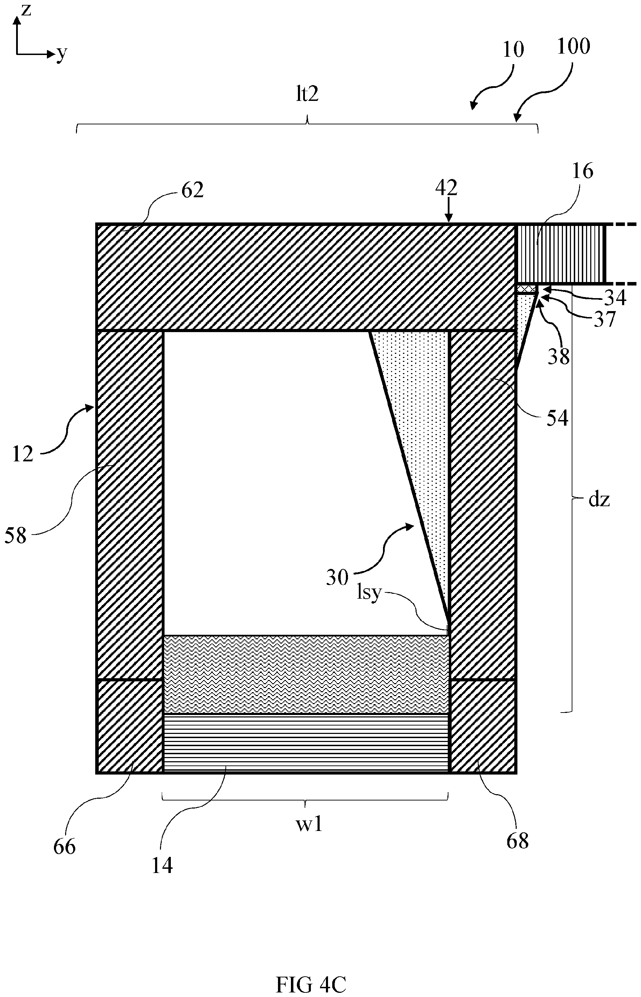

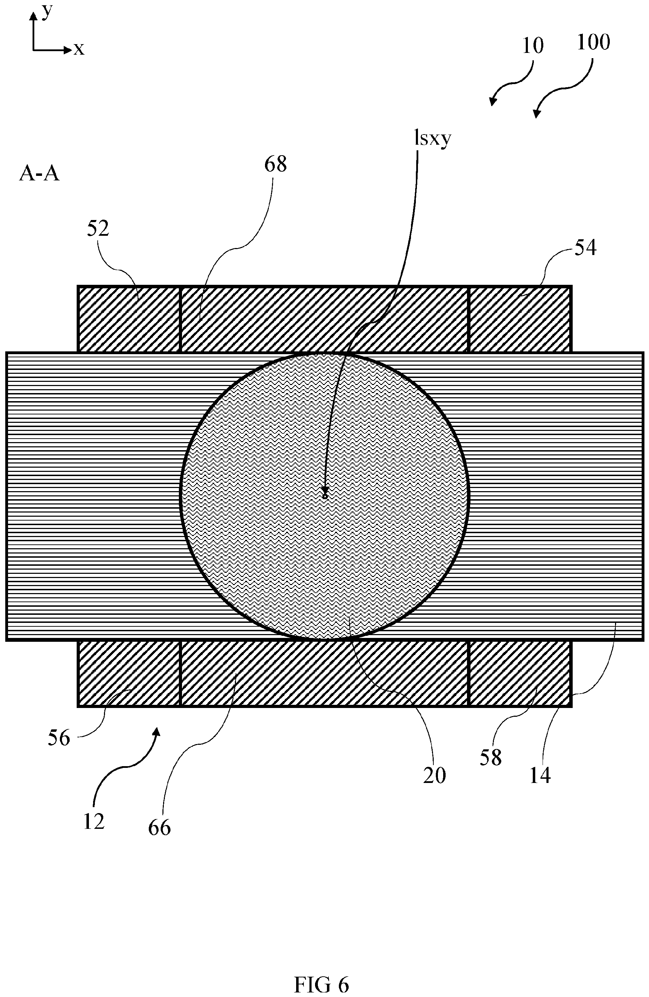

In this embodiment, the processing tool 30 has a probe in form of a tip 32 at its distal end. The processing tool 30 extends over a processing tool width wtx in the x-direction between its extension 31 to its extension 33 (cf. Fig. 3) and over a processing tool width wty in the y-direction between its extension 35 and its extension 37 (cf. Figs. 4B and 4C). The processing tool 30 has a static processing area lsxy defining an area over which the processing tool 30 processes the processing object 20 without moving the processing tool 30 (cf. Fig. 6). The static processing area lsxy is circular in this embodiment. In other embodiments, it may have a different geometry. The static processing area lsxy has a first static processing length lsx in the x-direction (cf. Fig. 3) and a second static processing length lsy in the y-direction (cf. Fig. 4A to 4C). The respective static processing length lsx and lsy define a length over which the processing tool 30 processes the processing object 20 in the respective direction without moving the processing tool 30 in the respective direction.

In this embodiment, the tool support 34 is arranged at the second translation axis 16 and supports the processing tool 30. The tool support 34 has a tool support width wsy larger than the second static processing length lsy of the processing tool 30 in the y-direction (cf. Fig. 4A) and a tool support width wsx larger than the first static processing length lsx of the processing tool 30 in the x-direction (cf. Fig. 3). In other embodiments the tool support width in the y-direction may be equal to or smaller than the second static processing length lsy. The processing tool width in the y-direction may be larger than the second static processing length of the processing tool in the y-direction.

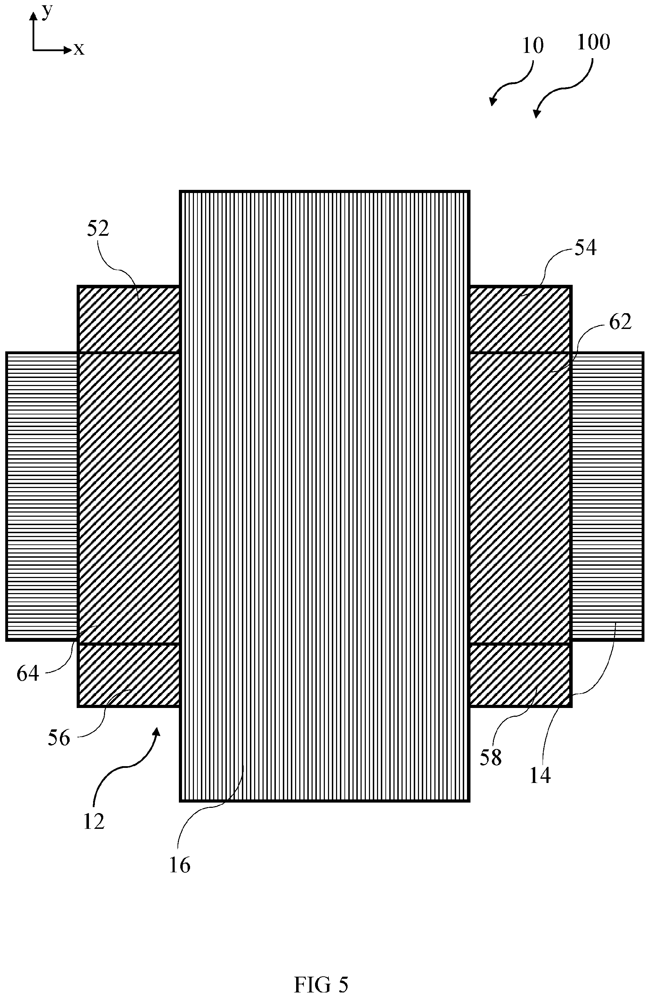

In this embodiment, the support structure 12 has four pillars 52, 54, 56, and 58 extending in a third direction z perpendicular to the x- and y-directions, two bars 62, 64 extending in the y-direction and two bars 66, 68 extending in the x-direction. The first translation axis 14 and the second translation axis 16 are arranged between the four pillars 52, 54, 56, and 58 as crossed axes (cf. Fig. 5) with a distance dz (cf. Fig. 3 and Figs. 4A to 4C) to each other in the z-direction. The pillars 52, 54, 56, and 58 are connected to the bars 62, 64, 66, and 68, such that that each of the pillars 52, 54, 56, 58 is connected to one bar 62, 64 extending in the y-direction and one bar 66, 68 extending in the x-direction and each of the bars 62, 64 extending in the y-direction is connected to two pillars 52, 54, 56, 58, and each of the bars 66, 68 extending in the x-direction is connected to two pillars 52, 54, 56, 58. The pillars and bars may be separate elements or the support structure may be made from one piece, e.g., a monobloc.

In this embodiment the support structure is made of granite. In other embodiments, the support structure may also be made of another material which preferably is strong and light.

The support structure 12 comprises one lateral opening 44 on both of its sides in the x-direction and one lateral opening 46 on both of its sides in the y-direction. The lateral openings 44 extend between the pillars 54 and 58 as well as 52 and 56. A span s1 between the pillars 54 and 58, as well as 52 and 56 in the y-direction is equal to the first translation axis width w1. The lateral openings 46 extend between the pillars 52 and 54 as well as 56 and 58. A span s2 between the pillars 52 and 54, as well as 56 and 58 in the x-direction is equal to the second translation axis width w2. The lateral openings 44 are at least as large as the processing object 20 such that the processing object 20 can be moved through them in order to place it below the processing tool 30. In the configuration shown in Fig. 2, a processing object 20 which has a smaller size than the lateral opening 44 is arranged on the first translation axis 14 while in Fig. 3 and Figs. 4A to 4C, and Fig. 6 a processing object 20 is arranged which is equal in size to the lateral openings 44. The lateral openings 46 are at least as large as the extensions 31, 33, 35, and 37 of the processing tool 30 (cf. Fig. 3 and Figs. 4B and 4C) such that the processing tool 30 can move through the lateral openings 46 without colliding with the support structure 12 when the second static processing length lsy is moved over the whole first translation axis width w1. Optimally, the lateral openings are as small as possible while still allowing the processing tool and processing object to move through them.

In other embodiments, instead of lateral openings, the support structure may also comprise one or more lateral recesses. The lateral recesses may be at least as large as extensions of the processing tool such that the processing tool can move into the lateral recesses without colliding with the support structure.

The second translation axis 16 moves the processing tool 30 over a second translation length lt2 in the y-direction that is larger than the first translation axis width w1 in the y-direction (cf. Figs. 4B and 4C) and shorter than the second translation axis length ly in the y-direction. The second translation length lt2 extends between a lowest extension 36 of the tool support 34 in the y-direction when at a lowest position 40 in the y-direction (cf. Fig. 4B) and a highest extension 38 of the tool support 34 in the y-direction when at a highest position 42 in the y-direction (cf. Fig. 4C). The extension of the second translation axis 16 to the left of the drawing due to sliding along the bars 62 and 64 in y-direction is indicated by dashed lines in Fig. 4B and its extension to the right of the drawing due to sliding along the bars 62 and 64 in y-direction is indicated by dashed lines in Fig. 4C. In this embodiment, the second translation length lt2 is equal to the sum of the first translation axis width w1 and the tool support width wsy minus the second static processing length lsy in the y-direction. In other embodiments, the second translation length lt2 may also be larger than the sum of the first translation axis width w1 and the tool support width wsy minus the second static processing length lsy in the y-direction.

Hence, the positioning system 10 is configured for moving the second static processing length lsy over the whole first translation axis width w1 without colliding with the support structure 12. This allows processing the processing object 20 with the processing tool 30 over the whole translation axis width w1 without colliding with the support structure 12. The spans s1 and s2 of the support structure 12 of the positioning system 10 can be reduced compared to positioning systems 1 known from the prior art. The span s1 in the y-direction only needs to have a width of the processing object 20 which can be as large as the first translation axis width w1 while still allowing processing of the whole processing object 20. The span s2 in the x-direction only needs to be as large as the processing tool width wtx and the tool support width wsx in the x-direction such that they can be moved in the y-direction for processing the processing object 20. In case that the spans s1 and s2 of the support structure 12 of the positioning system 10 have the same width, they can have a smaller width by a factor 2 compared to a span of the positioning system 1 known from the prior art.

In this embodiment, the resonance frequencies of the positioning system 10 are a factor two above the effective measurement bandwidth of the processing tool 30. This allows reducing influence of the positioning system on the processing tool results, in this case, AFM pictures when performing scans with high frequency such as 100 Hz. In other embodiments, the resonance frequencies of the positioning system may be above the effective processing bandwidth of the processing tool, e.g., at least a factor two above the effective processing bandwidth of the processing tool. Enhancing stiffness of the positioning system allows reducing amplitudes of resonances such that their effect on processing tool results can be diminished.

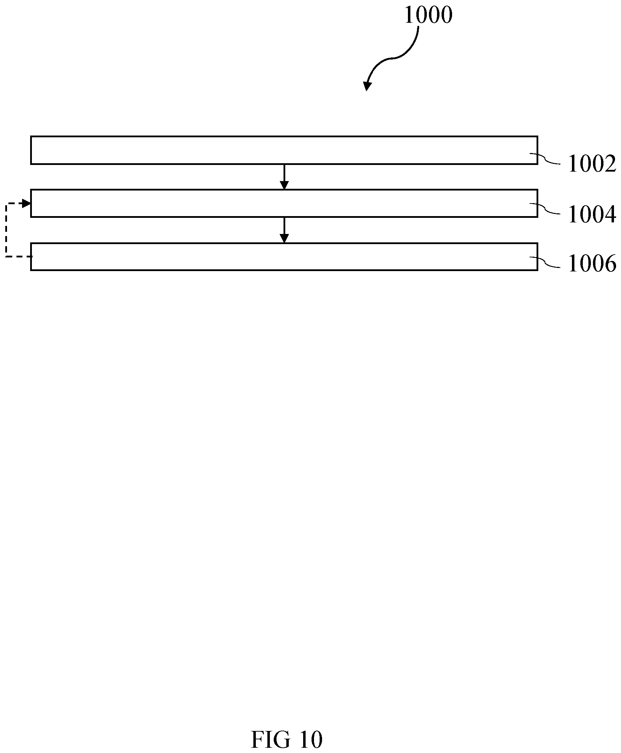

In this embodiment, a control unit 200 for controlling the processing system 100 is provided. The control unit 200 has a processor 202 and a computer readable medium in form of a memory 204. The control unit 200 is wirelessly connected to the processing system 100 to control the operation of the processing system 100. The computer readable medium stores a computer program product for operating the processing system 100 according to the embodiment of the method described with respect to Fig. 10. The computer program product comprises program code means for causing the processor 202 to carry out the method, when the computer program product is run on the processor 202.

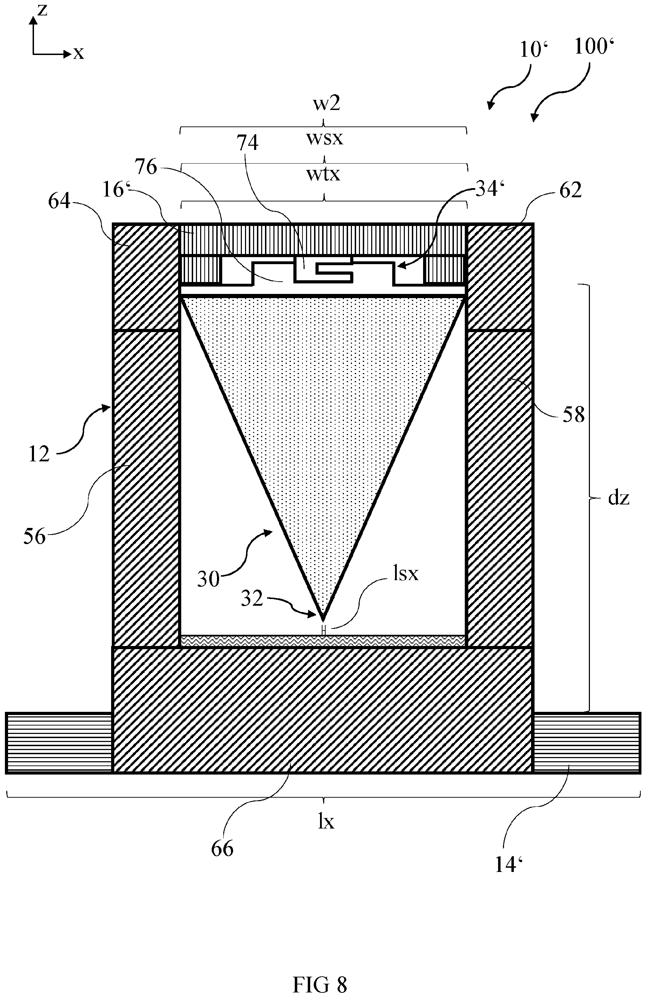

Fig. 7 shows schematically and exemplarily a perspective view of a second embodiment of the processing system 100' with a second embodiment of the positioning system 10' and a processing tool 30 in form of an AFM in a perspective view. The second embodiments of the processing system 100' and the positioning system 10' have a similar function and partly identical components as the first embodiments of the processing system 100 and the positioning system 10 described with respect to Figs. 2 to 6. In the following only differences between the embodiments are described. In contrast to the first embodiment of the positioning system 10, the second embodiment of the positioning system 10' has a first translation axis 14' and a second translation axis 16' in form of support bars which are fixedly connected to the support structure 12, as well as a tool support 34' which includes a rail 74 which supports a second translation stage 76 (cf. Fig. 8). In other embodiments, the first translation axis and/or the second translation axis may also be part of the support structure, e.g., if the support structure is a monobloc made of one material, such as granite.

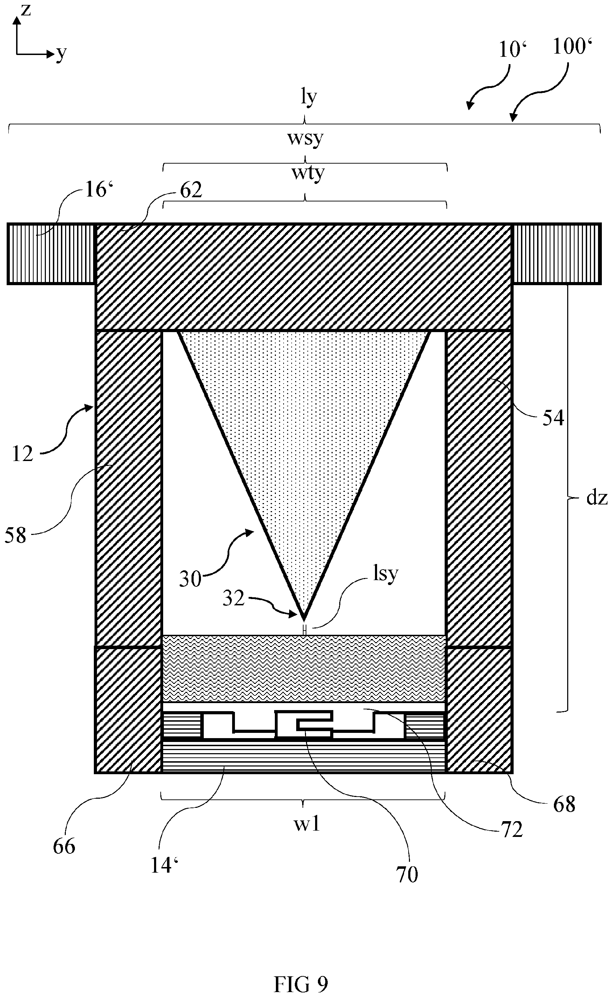

The first translation axis 14' includes a rail 70 for supporting a first translation stage 72 for supporting the processing object 20 and moves the first translation stage 72 along the rail 70 in the x-direction (cf. Fig. 9). In other embodiments, the first translation axis may also include more than one rail for supporting the first translation stage and for moving it along the x-direction.

The second translation axis 16' includes the rail 74 for supporting the second translation stage 76 for supporting the processing tool 30 and moves the second translation stage 76 along the rail 74 in the y-direction (cf. Fig. 8). In this embodiment, the rail 74 of the tool support 34' is part of the translation axis 16'. The second translation stage 76 defines the tool support width wsx in the x-direction and tool support width wsy in the y-direction and can move the processing tool 30 along the rail 74 in the y-direction to process the processing object 20 below the processing tool 30 along the y-direction (cf. Fig. 8). In other embodiments, the second translation axis may also include more than one rail for supporting the second translation stage and for moving it along the y-direction.

In this embodiment, the processing tool width wtx in the x-direction is equal to the tool support width wsx in the x-direction as well as the second translation axis width w2 in the x-direction (cf. Fig. 8) and the processing tool width wty in the y-direction is equal to the tool support width wsy in the y-direction as well as the first translation axis width w1 in the y-direction (cf. Fig. 9). This allows for providing a compact symmetric positioning system with high stability and improved positioning capabilities.

Fig. 10 shows an embodiment of the method 1000 for operating the processing system 100 or 100' as presented in Fig. 2 to 9.

In step 1002, a processing object in form of a sample is arranged on the first translation axis in case of the first embodiment and on a first translation stage which forms part of the first translation axis in case of the second embodiment.

In step 1004, the sample is moved along the x-direction to a position below the second translation axis, in particular below a position where the processing tool can process the sample.

In step 1006, the processing tool is moved along the y-direction. This allows processing the sample. In this embodiment, the second static processing length is moved over the whole first translation axis width by moving the processing tool. The processing tool can thus process the sample over the whole first translation axis width without colliding with the support structure.

Step 1004 and 1006 may be repeated until the whole area of the sample is processed. Therefore, step 1006 may be performed in form of a line scan along the y-direction and step 1004 may be performed stepwise in the x-direction to iteratively scan the whole area of the sample. Every other scanning pattern may be used, e.g., performing a line scan in the x-direction and stepwise movements in the y-direction. In other embodiments, the method may include further steps, e.g., removing the sample and applying another sample when the whole area of the sample has been processed.

While the invention has been illustrated and described in detail in the drawings and foregoing description, such illustration and description are to be considered illustrative or exemplary and not restrictive; the invention is not limited to the disclosed embodiments. For example, it is possible to operate the invention in an embodiment wherein the processing system is used for characterization of a sample, structuring of a sample, performing a scanning probe microscopy measurement on a sample, diamond cutting, polishing, FIB milling, performing lithography on the sample, local deposition of materials, local heating of a sample, inspection of roughness, inspection of critical dimensions, or any other processing, in particular processing performed on the nanoscale which requires low noise and high accuracy positioning.

Other variations to the disclosed embodiments can be understood and effected by those skilled in the art in practicing the claimed invention, from a study of the drawings, the disclosure, and the appended claims.

In the claims, the word "having", "comprising" and "including" does not exclude other elements or steps, and the indefinite article "a" or "an" does not exclude a plurality.

A single unit, processor, or device may fulfill the functions of several items recited in the claims. The mere fact that certain measures are recited in mutually different dependent claims does not indicate that a combination of these measures cannot be used to advantage.

Operations like arranging a processing object on the first translation axis, moving the processing object along the first direction to a position below the second translation axis, moving the processing tool along the second direction to move the second static processing length over the whole first translation axis width such that the processing tool processes the processing object over the whole first translation axis width without colliding with the support structure, et cetera performed by one or several units or devices can be performed by any other number of units or devices. These operations and/or the method can be implemented as program code means of a computer program and/or as dedicated hardware.

A computer program product may be stored/distributed on a suitable medium, such as an optical storage medium, or a solid-state medium, supplied together with or as part of other hardware, but may also be distributed in other forms, such as via the Internet, Ethernet, or other wired or wireless telecommunication systems.

Any reference signs in the claims should not be construed as limiting the scope.

The present invention relates to a positioning system for nanoscale positioning, as well as to a processing system comprising the positioning system. It comprises a support structure, a first translation axis and a second translation axis. The first translation axis extends along a first direction, for moving a processing object along the first direction and has a first translation axis width in a second direction perpendicular to the first direction. The second translation axis extends along the second direction, for moving a processing tool for processing the processing object along the second direction. The first and second translation axes are arranged with a distance to each other in a third direction perpendicular to the first and second directions and are connected to or part of the support structure. The positioning system is configured for moving the processing tool over the whole first translation axis width without colliding with the support structure.

## Claims

1. A positioning system (10; 10') for nanoscale positioning comprising:
- a support structure (12),
- a first translation axis (14; 14') extending along a first direction (x), for moving a processing object (20) along the first direction (x), and having a first translation axis width (w1) in a second direction (y) perpendicular to the first direction (x),
- a second translation axis (16; 16') extending along the second direction (y), for moving a processing tool (30) for processing the processing object (20) along the second direction (y), the processing tool (30) having a second static processing length (lsy) in the second direction (y) defining a length over which the processing tool (30) processes the processing object (20) without moving the processing tool (30) in the second direction (y), and
wherein the first translation axis (14; 14') is connected to or part of the support structure (12),
wherein the second translation axis (16; 16') is connected to or part of the support structure (12),
and wherein the first translation axis (14; 14') and the second translation axis (16; 16') are arranged with a distance (dz) to each other in a third direction (z) perpendicular to the first direction (x) and the second direction (y) and **characterized in that**
the positioning system (10; 10') is configured for moving the second static processing length (lsy) over the whole first translation axis width (w1) without colliding with the support structure (12).

2. Positioning system (10; 10') according to claim 1, wherein the positioning system (10; 10') comprises a tool support (34; 34') for supporting the processing tool (30), the tool support (34; 34') having a tool support width (wsy) larger than the second static processing length (lsy) of the processing tool (30) in the second direction (y).

3. Positioning system (10; 10') according to claim 2, wherein the second translation axis (16; 16') is configured for moving the processing tool (30) over a second translation length (lt2) in the second direction (y) that is larger than the first translation axis width (w1) in the second direction (y), the second translation length (lt2) extending between a lowest extension (36) of the tool support (34) in the second direction (y) when at a lowest position (40) in the second direction (y) and a highest extension (38) of the tool support (34) in the second direction (y) when at a highest position (42) in the second direction (y).

4. Positioning system (10; 10') according to claim 3, wherein the second translation length (lt2) is equal to or larger than the sum of the first translation axis width (w1) and the tool support width (wsy) minus the second static processing length (lsy) in the second direction (y).

5. Positioning system (10; 10') according to any of the claims 1 to 4, wherein the support structure (12) comprises at least one lateral opening (46) or lateral recess at at least one side of the support structure (12) in the second direction (y) which is at least as large as extensions (31, 33, 35, 37) of the processing tool (30) such that the processing tool (30) can move through the at least one lateral opening (46) or move into the at least one lateral recess without colliding with the support structure (12) when the second static processing length (lsy) is moved over the whole first translation axis width (w1).

6. Positioning system (10; 10') according to any of the claims 1 to 5, wherein the support structure (12) has four pillars (52, 54, 56, 58) extending in the third direction (z) and the first translation axis (14; 14') is arranged between the four pillars (52, 54, 56, 58) and the second translation axis (16; 16') is arranged between the four pillars (52, 54, 56, 58).

7. Positioning system (10; 10') according to claim 6, wherein a span (s1) between two of the pillars (54, 58) of the support structure (12) in the second direction (y) is equal to the first translation axis width (w1).

8. Positioning system (10; 10') according to claim 6 or 7, wherein the support structure (12) has two bars (62, 64) extending in the second direction (y) and two bars (66, 68) extending in the first direction (x), wherein each of the pillars (52, 54, 56, 58) is connected to one bar (62, 64) extending in the second direction (y) and one bar (66, 68) extending in the first direction (x) and each of the bars (62, 64) extending in the second direction (y) is connected to two pillars (52, 54, 56, 58) and each of the bars (66, 68) extending in the first direction (x) is connected to two pillars (52, 54, 56, 58).

9. Positioning system (10') according to any of the claims 1 to 8, wherein
- the first translation axis (14') includes at least one rail (70) for supporting a first translation stage (72) for supporting the processing object (20) and is configured for moving the first translation stage (72) along the at least one rail (70) in the first direction (x), and
- the second translation axis (16') includes at least one rail (74) for supporting a second translation stage (76) for supporting the processing tool (30) and is configured for moving the second translation stage (76) along the at least one rail (74) in the second direction (y).

10. Processing system (100; 100') including a positioning system (10; 10') according to any of the claims 1 to 9 and a processing tool (30) for processing the processing object (20) having the second static processing length (lsy) of the processing tool (30) in the second direction (y) defining the length over which the processing tool (30) processes the processing object (20) without moving the processing tool (30) in the second direction (y).

11. Processing system (100; 100') according to claim 10, wherein the resonance frequencies of the positioning system (10; 10') are at least a factor two above an effective processing bandwidth of the processing tool (30).

12. Method (1000) for operating a processing system according to claim 10 or 11, comprising the steps:
- arranging a processing object on the first translation axis (1002),
- moving the processing object along the first direction to a position below the second translation axis (1004),
- moving the processing tool along the second direction to move the second static processing length over the whole first translation axis width such that the processing tool processes the processing object over the whole first translation axis width without colliding with the support structure (1006).

13. Use of the processing system (100; 100') according to claim 10 or 11 for
- characterization of a sample (20),
- structuring of a sample (20),
- performing a scanning probe microscopy measurement on a sample (20),
- diamond cutting,
- polishing,
- focused ion beam milling,
- performing lithography on the sample (20),
- local deposition of materials,
- local heating of a sample (20),
- inspection of roughness, or
- inspection of critical dimensions.

14. Computer program product for operating a processing system (100; 100') according to claim 10 or 11, wherein the computer program product comprises program code means for causing a processor (202) to carry out the method as defined in claim 12, when the computer program product is run on the processor (202).

15. Computer readable medium (204) having stored the computer program product of claim 14.
